# EUROPÄISCHE PATENTANMELDUNG

(11) **EP 1 424 404 A2**
(43) Veröffentlichungstag der Anmeldung: **02.06.2004**
(21) Anmeldenummer: 03026360.2
(22) Anmeldetag: 18.11.2003
(51) Int. Cl.: C23C 14/26

(54) **Bedampfungsvorrichtung**

(30) Priorität: 30.11.2002 DE 10256038
(71) Anmelder: Applied Films GmbH & Co. KG, 63755 Alzenau (DE)
(72) Erfinder: Hoffmann, Uwe, Dr., 63755 Alzenau (DE); Jischke, Andreas, 63796 Kahl (DE); Klöppel, Andreas, 63695 Glauburg (DE); Sauer, Peter, 36381 Schlüchtern (DE)
(74) Vertreter: Hebing, Norbert

(57) **Zusammenfassung**

Eine Bedampfungsvorrichtung zum Bedampfen von vertikal ausgerichteten Bereichen eines Substrates hat einen stehend angeordneten, elektrisch beheizten Schmelztiegel (2) mit einer elektrischen Heizung (11) für das zu verdampfende Material. Auf dem Schmelztiegel (2) sitzt von oben her ein vom Schmelztiegel (2) separates, an seiner oberen Seite verschließbares Düsenrohr (3), welches zum Bedampfen des Substrates einen Dampfauslass (8) aufweist. Das Düsenrohr (3) hat eine von der Heizung (11) des Schmelztiegels (2) unabhängige Heizung (10).

## Beschreibung

Die Erfindung betrifft eine Bedampfungsvorrichtung zum Bedampfen von vertikal ausgerichteten Bereichen eines Substrates, bei welcher ein aufrecht stehender Schmelztiegel mit einer Heizung zum Schmelzen und Verdampfen von in dem Schmelztiegel eingefülltem Material angeordnet ist und die eine Umlenkeinrichtung zum Umlenken des vertikal aus dem Schmelztiegel strömenden Dampfes horizontal zu dem Substrat hin aufweist.

Eine Bedampfungsvorrichtung der vorstehenden Art ist Gegenstand der DE 17 96 166 B2. Bei der Bedampfungsvorrichtung gemäß dieser Schrift wird das zu verdampfende Material mittels Elektronenbeschuss verdampft. Die Umlenkeinrichtung ist durch eine oberhalb des Schmelztiegels angeordnete Elektrode des zur Verdampfung benutzten Elektrodensystems gebildet. Nachteilig bei der bekannten Bedampfungsvorrichtung ist es, dass der horizontal abströmende Dampf sich hinsichtlich der Verteilung seiner Dampfteilchen nicht zu vergleichmäßigen vermag und über einen sehr großen Querschnitt zum Substrat hin strömt. Weiterhin besteht die Gefahr, dass es zu einer Beschichtung der Umlenkeinrichtung kommt, wodurch ihre Wirkung nachlässt. Da die bekannte Bedampfungsvorrichtung eine Heizung mittels Elektronenbeschuss bedingt, hat sie nur eine relativ geringe Leistung.

Durch die US 4,880,960 ist auch schon eine Bedampfungsvorrichtung bekannt geworden, bei der anstelle eines Schmelztiegels ein relativ langer, stehend angeordneter Zylinder verwendet wird, der an seinem oberen Ende verschlossen ist und über seine gesamte Länge durch eine elektrische Widerstandsheizung beheizt ist. Der Zylinder hat als Dampfauslass in seiner Mantelfläche ein Fenster, welches an seiner Außenseite durch ein Sieb abgedeckt ist, damit in den Zylinder von oben her gelangendes, zu verdampfendes Material nicht unmittelbar durch das Fenster nach außen fallen kann. Der Zylinder wird außenseitig von mehreren Strahlblechen konzentrisch umschlossen, die zum Durchlass des Dampfes ein Dampfdurchlassfenster aufweisen.

Die bekannte Bedampfungsvorrichtung ist zum Verdampfen von Magnesium vorgesehen. Magnesium hat die Eigenschaft, im Vakuum bei Temperaturen von etwa 500 °C zu sublimieren. Deshalb wird gemäß der US 4,880,960 dieses Magnesium kontinuierlich in Form von Pulver mit einer Korngröße von 0,3 bis 2,5 mm von oben her in den Zylinder eingegeben. Während des Herunterfallens wandelt sich dieses Pulver aufgrund der Wärmestrahlung in Dampf um, der den Zylinder über seinen Dampfauslass verlässt. Da im Zylinder über seine gesamte Länge das Pulver vorhanden ist, muss der Dampfauslass von einem Sieb abgedeckt werden, weil anderenfalls Feststoffteilchen mit dem Dampf aus der Bedampfungsvorrichtung austreten und zum Substrat gelangen könnten. Die Anordnung eines solchen Siebes soll zwar einen Austritt von Pulver verhindern. In der Praxis lässt sich das jedoch nicht völlig ausschließen, da ein Sieb grundsätzlich nur solche Feststoffteilchen zurückhalten kann, die größer als seine Maschenweite sind und die eingegebenen Teilchen durch die Verdampfung so lange kleiner werden, bis sie vollständig verdampft sind. Diese feinen Feststoffteilchen könnten durch das Sieb hindurch zu dem zu beschichtenden Substrat gelangen.

Der Erfindung liegt das Problem zugrunde, eine Bedampfungsvorrichtung der eingangs genannten Art so auszubilden, dass der von einem Schmelztiegel ausgehende und in vertikaler Richtung aufsteigende Dampf mit keulenförmiger Verteilung der Dampfteilchen so umgelenkt wird, dass eine gleichförmige Verteilung entsteht und keine Feststoffteilchen vom Verdampfer auf das zu beschichtende Substrat zu gelangen vermögen.

Dieses Problem wird erfindungsgemäß dadurch gelöst, dass die Umlenkeinrichtung als ein auf dem Schmelztiegel von oben her aufsitzendes, an seiner oberen Seite verschließbares Düsenrohr ist, welches in seiner Mantelfläche einen horizontalen Dampfauslass aufweist, und dass das Düsenrohr eine von der Heizung des Schmelztiegels unabhängige Heizung hat.

Eine solche Bedampfungsvorrichtung hat einen üblichen Schmelztiegel, in welchen man das Verdampfungsgut als so große, feste Teilchen eingeben kann, dass zunächst eine Schmelze entsteht, durch die anschließend der zu erzeugende Dampf gebildet wird. Deshalb können keine feinen Teilchen mit dem Dampf zum Substrat gelangen. Gemäß der Erfindung wird die Funktion der Dampferzeugung und der Dampfabgabe zum Substrat hin voneinander getrennt. Da durch die separaten Heizungen der Schmelztiegel und das Düsenrohr unabhängig voneinander beheizbar sind, kann man bei Betrieb der Bedampfungsvorrichtung dafür sorgen, dass die Temperatur im Düsenrohr stets etwa 100 °C bis 200 °C höher liegt als im Schmelztiegel, so dass es zu keiner Kondensation von Dampf im Düsenrohr und damit zu einer Beschichtung des Düsenrohres kommen kann. Durch die Verwendung eines üblichen Schmelztiegels eignet sich die erfindungsgemäße Bedampfungsvorrichtung für das Aufschmelzen und Verdampfen sehr unterschiedlicher Materialien, beispielsweise Al, Ag, Cr.

Besonders vorteilhaft ist es, wenn gemäß einer Weiterbildung der Erfindung im Bereich des Schmelztiegels und im Bereich des Düsenrohres jeweils ein Temperaturfühler zum Regeln der Leistung der Heizung des Schmelztiegels und des Düsenrohres vorgesehen ist. Hierdurch hat man die Möglichkeit, im Düsenrohr und im Schmelztiegel die Temperatur optimal zu regeln, was zugleich für eine Verringerung des Energiebedarfes sorgt, weil keine unnötig hohen Temperaturen in einem der Bauteile erzeugt werden müssen, um zu niedrige Temperaturen im jeweils anderen Bauteil auszuschließen.

Die Befestigung des Düsenrohres am Schmelztiegel ist besonders einfach ausgebildet, wenn das Düsenrohr am unteren Ende mit einer Durchmesserverjüngung in den Schmelztiegel eingreift.

Eine andere vorteilhafte Weiterbildung der Erfindung besteht darin, dass das Düsenrohr am oberen Ende eine kegelstumpfförmige Verjüngung mit einer koaxialen Befüllungsöffnung aufweist und dass in diese Befüllungsöffnung von oben her ein höhenverfahrbarer Stempel einfahrbar ist. Ein solcher Stempel hat eine Doppelfunktion. Er ist einerseits Verschlussteil für die Befüllungsöffnung, so dass während des Betriebs der Verdampfungsvorrichtung Dampf ausschließlich aus dem Dampfauslass des Düsenrohres austritt, andererseits hält der Stempel das obere Ende des Düsenrohres in koaxialer Ausrichtung zum Schmelztiegel.

Die Wärmeabgabe der Heizung des Schmelztiegels und des Düsenrohres wird zum Schmelztiegel und dem Düsenrohr gerichtet, wenn das Düsenrohr konzentrisch von mehreren Strahlblechen umgeben ist, welche im Bereich des Dampfauslasses ein Dampfdurchlassfenster aufweisen.

Die Bedampfungsvorrichtung bildet ein thermisch geschlossenes System und belastet deshalb die sie aufnehmende Beschichtungskammer nicht mit Wärmestrahlung, wenn die Strahlbleche außenseitig von einem Verdampfergehäuse umschlossen sind, welches außenseitig Kühlrohre aufweist und im Bereich des Dampfdurchlassfensters und des Dampfauslasses eine Abdampföffnung hat. Durch diese Gestaltung erübrigt sich eine Wärmeisolation der Bedampfungsvorrichtung mittels Isoliermaterial, so dass die Bedampfungsvorrichtung hochvakuumtauglich wird, weil kein Wärmedämmmaterial vorhanden ist, das eine große innere Oberfläche aufweist, von der adsorbierte Gase während des Betriebes desorbieren, in die Vakuumkammer gelangen und das Schichtmaterial verunreinigen.

Die Kühlrohre behindern nicht den freien Querschnitt des Dampfdurchlassfensters, wenn sie im Bereich des Düsenrohres mäanderförmig ausgerichtet sind und in Längsrichtung der Verdampfungsvorrichtung verlaufende lange Rohrabschnitte aufweisen, welche abwechselnd oben und unten durch jeweils einen kurzen Rohrabschnitt miteinander verbunden sind.

Die Kühlrohre für das Gehäuse im Bereich des Schmelztiegels können besonders wirksam angeordnet sein, indem sie dort schraubenlinienförmig um das Verdampfergehäuse herum führen.

Der Dampfauslass ermöglicht einen gleichmäßigen Dampfaustritt mit ausreichend hohen Dampfgeschwindigkeiten, um den Dampf zuverlässig zum Substrat gelangen zu lassen, wenn gemäß einer anderen Weiterbildung der Erfindung der Dampfauslass im Düsenrohr durch mehrere, übereinander angeordnete Bohrungen gebildet ist.

Der Schmelztiegel und das Düsenrohr sind für das Verdampfen von Silber oder anderen bei hohen Temperaturen schmelzenden Metallen optimal beschaffen, wenn der Schmelztiegel und das Düsenrohr aus Graphit bestehen.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in
- Fig.1: einen senkrechten Schnitt durch eine Verdampfungsvorrichtung nach der Erfindung,
- Fig.2: eine perspektivische Ansicht der Verdampfungsvorrichtung.

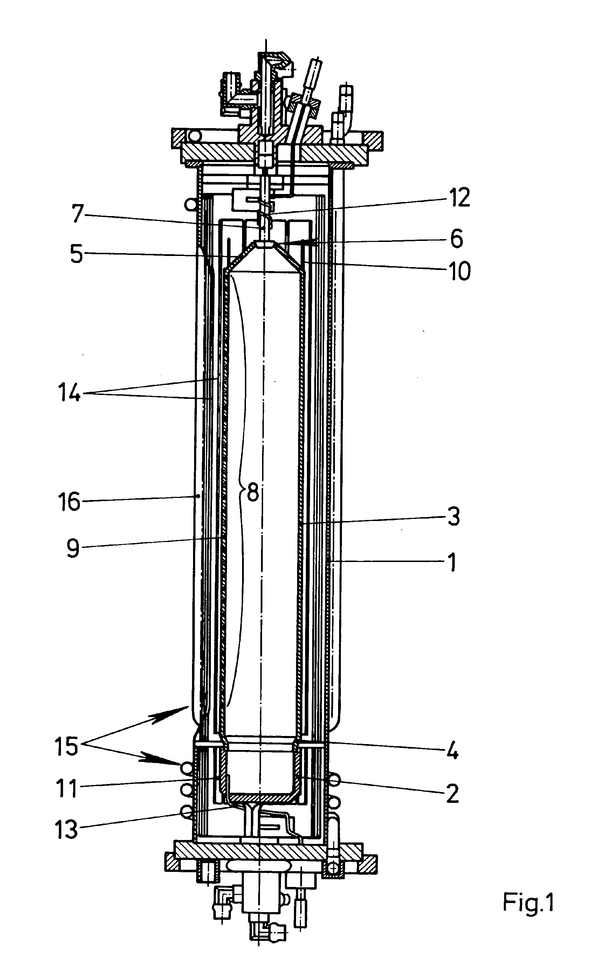

Die in Figur 1 im Längsschnitt gezeigte Verdampfungsvorrichtung hat ein Verdampfergehäuse 1, in welchem ein Schmelztiegel 2 aus Graphit stehend angeordnet ist. Von oben her greift in diesen Schmelztiegel 2 ein Düsenrohr 3, welches ebenfalls aus Graphit besteht. Das Düsenrohr 3 hat an seinem unteren Ende eine Durchmesserverjüngung 4, mit der es von oben her in den Schmelztiegel 2 greift. An seinem oberen Ende weist das Düsenrohr 3 eine kegelstumpfförmige Verjüngung 5 mit einer koaxialen Befüllungsöffnung 6 auf, in die von oben her ein Stempel 7 greift. Dadurch zentriert der Stempel 7 das obere Ende des Düsenrohres 3 und drückt das Düsenrohr 3 mit seiner Verjüngung 4 gegen den Schmelztiegel 2.

An der linken Seite des Düsenrohres 3 erkennt man in der Figur 1 einen Dampfauslass 8, der durch mehrere, übereinander angeordnete Bohrungen 9 in der Wand des Düsenrohres 3 gebildet ist. Zur Beheizung des Düsenrohres 3 dient eine elektrische Heizung 10, während für die Beheizung des Schmelztiegels 2 eine hiervon unabhängige Heizung 11 vorgesehen ist. Ein Temperaturfühler 12 im Bereich des Stempels 7 dient zur Regelung der Heizung 10 des Düsenrohres 3. Entsprechend wird zur Regelung der Heizung 11 des Schmelztiegels 2 die Temperatur der Schmelztiegelwandung mittels eines Temperaturfühlers 13 gemessen.

Entlang der Außenseite des Verdampfergehäuses 1 verlaufen Kühlrohre 15. Diese bilden im Bereich des Schmelztiegels 2 eine umlaufende Wendel. Im Bereich des Düsenrohres 3 weisen sie in Längsrichtung des Düsenrohres 3 verlaufende gerade Rohrbereiche auf.

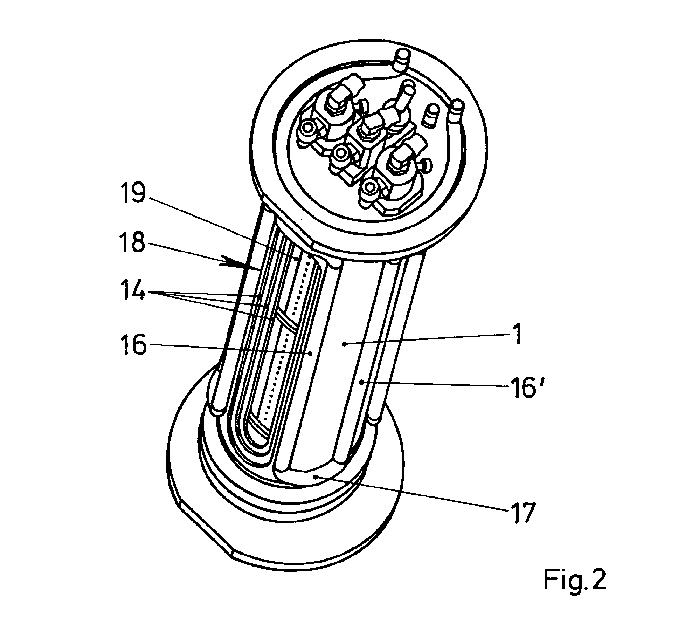

Die Figur 2 zeigt, wie die in Längsrichtung verlaufenden Rohrabschnitte 16, 16' im unteren Bereich durch einen kurzen, in Umfangsrichtung verlaufenden Rohrabschnitt 17 miteinander verbunden sind. Da die Rohrabschnitte 16 abwechselnd oben und unten durch solche kurzen Rohrabschnitte 17 verbunden sind, ergibt sich ein mäanderförmiger Rohrverlauf im Bereich des in Figur 1 gezeigten Düsenrohres 3. Die Figur 2 lässt weiterhin im Verdampfergehäuse 1 eine Abdampföffnung 17 erkennen. Hinter dieser Abdampföffnung 17 weisen die Strahlbleche 14 ein entsprechendes Dampfdurchlassfenster 18 auf.

### Bezugszeichenliste

- 1: Verdampfergehäuse
- 2: Schmelztiegel
- 3: Düsenrohr
- 4: Durchmesserverjüngung
- 5: Verjüngung

- 6: Befüllungsöffnung
- 7: Stempel
- 8: Dampfauslass
- 9: Bohrung
- 10: Heizung

- 11: Heizung
- 12: Temperaturfühler
- 13: Temperaturfühler
- 14: Strahlblech
- 15: Kühlrohr

- 16: Rohrabschnitt
- 17: Rohrabschnitt
- 18: Abdampföffnung
- 19: Dampfdurchlassfenster

## Patentansprüche

1. Bedampfungsvorrichtung zum Bedampfen von vertikal ausgerichteten Bereichen eines Substrates, bei welcher ein aufrecht stehender Schmelztiegel (2) mit einer Heizung (11) zum Schmelzen und Verdampfen von in dem Schmelztiegel eingefülltem Material angeordnet ist und die eine Umlenkeinrichtung zum Umlenken des vertikal aus dem Schmelztiegel (2) strömenden Dampfes horizontal zu dem Substrat hin aufweist, **dadurch gekennzeichnet, dass** die Umlenkeinrichtung ein auf dem Schmelztiegel (2) von oben her aufsitzendes, an seiner oberen Seite verschließbares Düsenrohr (3) ist, welches in seiner Mantelfläche einen horizontalen Dampfauslass (8) aufweist, und dass das Düsenrohr (3) eine von der Heizung (11) des Schmelztiegels (2) unabhängige Heizung (10) hat.

2. Bedampfungsvorrichtung nach Anspruch 1, **dadurch gekennzeichnet, dass** im Bereich des Schmelztiegels (2) und im Bereich des Düsenrohres (3) jeweils ein Temperaturfühler (13, 12) zum Regeln der Leistung der Heizung (11, 10) des Schmelztiegels (2) und des Düsenrohres (3) vorgesehen ist.

3. Bedampfungsvorrichtung nach den Ansprüchen 1 oder 2, **dadurch gekennzeichnet, dass** das Düsenrohr (3) am unteren Ende mit einer Durchmesserverjüngung (4) in den Schmelztiegel (2) eingreift.

4. Bedampfungsvorrichtung nach zumindest einem der vorangehenden Ansprüche, **dadurch gekennzeichnet, dass** das Düsenrohr (3) am oberen Ende eine kegelstumpfförmige Verjüngung (5) mit einer koaxialen Befüllungsöffnung (6) aufweist und dass in diese Befüllungsöffnung (6) von oben her ein höhenverfahrbarer Stempel (7) einfahrbar ist.

5. Bedampfungsvorrichtung nach zumindest einem der vorangehenden Ansprüche, **dadurch gekennzeichnet, dass** das Düsenrohr (3) konzentrisch von mehreren Strahlblechen (14) umgeben ist, welche im Bereich des Dampfauslasses (8) ein Dampfdurchlassfenster aufweisen.

6. Bedampfungsvorrichtung nach zumindest einem der vorangehenden Ansprüche, **dadurch gekennzeichnet, dass** die Strahlbleche (14) außenseitig von einem Verdampfergehäuse (1) umschlossen sind, welches außenseitig Kühlrohre (15) aufweist und im Bereich des Dampfdurchlassfensters und des Dampfauslasses eine Abdampföffnung hat.

7. Bedampfungsvorrichtung nach Anspruch 6, **dadurch gekennzeichnet, dass** die Kühlrohre (15) im Bereich des Düsenrohres (3) mäanderförmig ausgerichtet sind und in Längsrichtung der Verdampfungsvorrichtung verlaufende lange Rohrabschnitte (16, 16') aufweisen, welche abwechselnd oben und unten durch jeweils einen kurzen Rohrabschnitt (17) miteinander verbunden sind.

8. Bedampfungsvorrichtung nach Anspruch 6, **dadurch gekennzeichnet, dass** die Kühlrohre (15) im Bereich des Schmelztiegels (2) schraubenlinienförmig um das Verdampfergehäuse (1) herum führen.

9. Bedampfungsvorrichtung nach zumindest einem der vorangehenden Ansprüche, **dadurch gekennzeichnet, dass** der Dampfauslass (8) im Düsenrohr (3) durch mehrere, übereinander angeordnete Bohrungen (9) gebildet ist.

10. Bedampfungsvorrichtung nach zumindest einem der vorangehenden Ansprüche, **dadurch gekennzeichnet, dass** der Schmelztiegel (2) und das Düsenrohr (3) aus Graphit bestehen.
